(19) Europäisches Patentamt / European Patent Office / Office européen des brevets

(11) **EP 2 361 389 B1**

(12) **FASCICULE DE BREVET EUROPEEN**

(45) Date de publication et mention de la délivrance du brevet:
**15.08.2012 Bulletin 2012/33**

(21) Numéro de dépôt: **09783967.4**

(22) Date de dépôt: **13.10.2009**

(51) Int Cl.:
*G01R 31/11* (2006.01)      *H04L 12/26* (2006.01)
*G01R 31/00* (2006.01)      *G01R 31/08* (2006.01)

(86) Numéro de dépôt international:
**PCT/EP2009/063318**

(87) Numéro de publication internationale:
**WO 2010/043602 (22.04.2010 Gazette 2010/16)**

(54) **DISPOSITIF ET PROCEDE DE REFLECTOMETRIE DISTRIBUEE POUR LE DIAGNOSTIC D'UN RESEAU DE TRANSMISSION**

EINRICHTUNG UND VERFAHREN DER VERTEILTEN REFLEKTROMETRIE ZUR DIAGNOSTIZIERUNG EINES ÜBERTRAGUNGSNETZES

DEVICE AND METHOD OF DISTRIBUTED REFLECTOMETRY FOR DIAGNOSING A TRANSMISSION NETWORK

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **15.10.2008 FR 0856992**

(43) Date de publication de la demande:
**31.08.2011 Bulletin 2011/35**

(73) Titulaire: **Commissariat à l'Energie Atomique 75015 Paris (FR)**

(72) Inventeur: **LELONG, Adrien 94200 IVRY SUR SEINE (FR)**

(74) Mandataire: **Ilgart, Jean-Christophe et al Brevalex 95, rue d'Amsterdam F-75378 Paris Cedex 8 (FR)**

(56) Documents cités:
**FR-A- 2 907 910      US-A- 5 534 783**

• **NISHIYAMA E ET AL: "A method for fault detecting on twisted pair cable network by use of M-sequence correlation" INDUSTRIAL ELECTRONICS SOCIETY, 2004. IECON 2004. 30TH ANNUAL CONFEREN CE OF IEEE BUSAN, SOUTH KOREA 2-6 NOV. 2004, PISCATAWAY, NJ, USA,IEEE, vol. 2, 2 novembre 2004 (2004-11-02), pages 1929-1934, XP010799107 ISBN: 978-0-7803-8730-0**
• **NAIK S ET AL: "Multicarrier reflectometry" IEEE SENSORS JOURNAL, IEEE SERVICE CENTER, NEW YORK, NY, US, vol. 6, no. 3, 1 juin 2006 (2006-06-01), pages 812-818, XP002507430 ISSN: 1530-437X cité dans la demande**
• **SMITH P ET AL: "Analysis of spread spectrum time domain reflectometry for wire fault location" IEEE SENSORS JOURNAL, IEEE SERVICE CENTER, NEW YORK, NY, US, vol. 5, no. 6, 1 décembre 2005 (2005-12-01), pages 1469-1478, XP001512966 ISSN: 1530-437X cité dans la demande**
• **N. RAVOT ET AL: 'Distributed reflectometry-based diagnosis for complex wired networks' EMC:SAFETY, RELIABILITY AND SECURITY OF COMMUNICATION AND TRANSPORTATION SYST, EMC WORKSHOP 01 Juin 2007, EMC WORKSHOP, PARIS, pages 1 - 1, XP055020098**

EP 2 361 389 B1

**Description**

**DOMAINE TECHNIQUE**

L'invention concerne un dispositif et un procédé de réflectométrie distribuée pour le diagnostic d'un réseau de transmission, par exemple d'un réseau filaire.

Le domaine de l'invention est notamment celui du diagnostic embarqué de réseaux câblés par réflectométrie.

**ÉTAT DE LA TECHNIQUE ANTÉRIEURE**

La réflectométrie consiste à émettre un signal sur un réseau de câbles puis à mesurer les échos renvoyés. Le retard et l'amplitude de ces échos permettent d'obtenir des informations sur la structure ou sur les défauts électriques présents dans ce réseau. Plus généralement, chaque écho correspond à une singularité. On peut ainsi localiser, caractériser et éventuellement prédire une panne. Les méthodes classiques bien connues de réflectométrie sont la TDR (« Time Domain Reflectometry ») et la FDR (« Frequency Domain Reflectometry »).

Le but de la réflectométrie est de retracer les variations brusques de l'impédance caractéristique d'une ou plusieurs lignes de transmission qui peuvent correspondre à des branches ou des défauts (court-circuit, ou circuit ouvert), en déterminant les coefficients de réflexion $\alpha_k$ de la ou des lignes.

Le principe de la réflectométrie est basé sur la propagation d'ondes de tension dans ces lignes. Il consiste à envoyer un signal connu x(t) dans une ligne électrique et à mesurer ensuite le signal $x_s$(t) que renvoie la ligne. La mesure qui est faite est alors composée de l'ensemble des échos dus aux variations de l'impédance caractéristique de la ligne. L'analyse de la mesure $x_s$(t) par rapport au signal original x(t) donne une estimation de la réponse de la ligne.

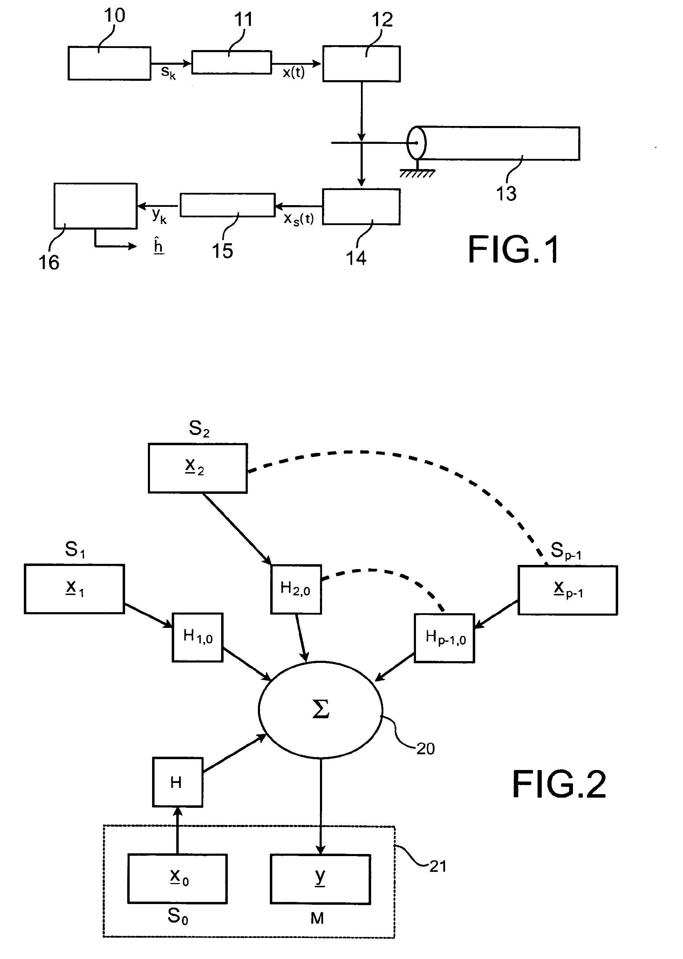

Le schéma de la figure 1 illustre le fonctionnement général d'un dispositif de réflectométrie. Sur cette figure sont représentées :

- une partie émission qui comprend :

  - un générateur de forme 10,
  - un convertisseur numérique-analogique 11,
  - un premier dispositif de couplage électrique 12 relié à la ligne à diagnostiquer 13,

- une partie réception qui comprend :

  - un second dispositif de couplage électrique 14 relié à la ligne 13,
  - un convertisseur analogique-numérique 15,
  - un dispositif de moyennage et de traitement du signal 16.

Le signal x(t) envoyé sur la ligne 13 par la partie émission est soumis à des contraintes propres à l'application et à la méthode de réflectométrie utilisée. Ces contraintes résultent des problèmes d'interférence entre le signal de réflectrométrie et le signal cible. Le couplage électrique est une partie purement électrique qui a pour rôle de réaliser l'interfaçage entre le dispositif de réflectométrie (émission, réception du signal) et la ligne 13 en assurant des fonctions telles que l'adaptation d'impédance, la protection électrique ou encore un éventuel filtrage.

La relation entre $x_s$(t) et x(t) est donnée par la relation : $x_s$(t)=x(t)*h(t), * représentant le produit de convolution. Dans le domaine fréquentiel on obtient la relation : $X_s$(*f*)=X(*f*)H(*f*).

On peut considérer, en première approximation, que h(t) est une suite d'impulsions de type dirac correspondant à l'expression :

$$h(t) = \sum \alpha_k \delta(t - \tau_k) \qquad (1)$$

Dans les systèmes de diagnostic, la réflectométrie est généralement réalisée par un système numérique. On travaille alors sur des signaux échantillonnés, et le résultat final à savoir la réponse impulsionnelle est également échantillonnée (ou discrétisée).

Le signal test est défini par le vecteur $\underline{s}$=($s_0$, $s_1$, ..., $s_{N-1}$), N étant le nombre d'échantillons correspondant à une période. Ce signal peut être émis de façon périodique ou non en fonction du type de signal et des traitements effectués par le système. Lorsque l'émission est périodique de période N, le signal de mesure obtenu après échantillonnage est donné par

$$\hat{\underline{y}} = H\underline{s} + \underline{n} \qquad\qquad (2)$$

$\underline{y} = (y_0, y_1, y_{N-1})$ : signal de mesure discrétisé, n représente le bruit additif de mesure.
H est la matrice MxN correspondant à la réponse impulsionnelle de la ligne discrétisée.

$$H = \begin{pmatrix} h_0 & h_1 & \cdots & h_{N-1} \\ h_{N-1} & h_0 & \cdots & h_{N-1} \\ \vdots & \ddots & \ddots & \vdots \\ h_1 & h_2 & \cdots & h_0 \\ & & & \end{pmatrix}$$

Cette matrice H représente l'opération de convolution. Un post-traitement du signal $\hat{y}$ permet ensuite de récupérer une estimation de la réponse impulsionnelle de la ligne qui peut être analysée pour détecter d'éventuels défauts.

En pratique, il est souvent intéressant de réaliser plusieurs mesures et d'en calculer la moyenne afin d'améliorer le rapport signal à bruit. En effet, le signal test étant émis de façon périodique, si l'on considère que la réponse h de la ligne varie lentement par rapport à la période $T=NT_e$, on peut considérer que le signal reste stationnaire sur plusieurs mesures. Le signal de mesure final est alors obtenu par

$$\hat{\underline{y}} = \frac{1}{M} \sum_{m=0}^{M-1} \underline{y}^{(m)} \qquad\qquad (3)$$

M : est le nombre de mesures
$\underline{y}^{(m)}$ : est la $m^{\text{ème}}$ mesure.

L'objectif de la réflectométrie distribuée est de pouvoir effectuer plusieurs mesures réflectométriques simultanément en plusieurs points d'un réseau filaire afin de résoudre les ambiguités liées à la topologie.

La réflectométrie distribuée permet de réaliser simultanément des mesures de diagnostic en plusieurs points d'un réseau, plusieurs réflectomètres étant connectés à ce réseau et émettant un signal test en même temps. Le problème résolu par cette méthode est celui du parasitage de la mesure de chaque réflectomètre par les signaux de test des autres réflectomètres, qui nécessite d'appliquer un traitement sur le signal reçu. La réflectométrie distribuée permet ainsi de résoudre certaines ambiguïtés liées à la structure du réseau. Pour illustrer ce problème d'ambiguïté, on peut citer le cas d'un réseau en Y. Lorsque l'on détecte un défaut dans un tel réseau on connaît la distance qui le sépare du point de mesure mais on ne peut pas toujours déterminer la branche sur laquelle il se trouve. La réflectométrie distribuée permet entre autre de résoudre ce type d'ambiguïté, en réalisant un traitement qui consiste à discriminer les signaux issus des différents réflectomètres afin de ne conserver que le signal intéressant. On qualifie d'algorithme de discrimination le traitement permettant de réaliser cette fonctionnalité.

Comme illustré sur la figure 2, p réflectomètres sont ainsi connectés à un réseau 20 et émettent un signal de test en même temps. Chaque réflectomètre mesure les échos liés à son propre signal test mais également à ceux des autres. Ces autres signaux constituent un bruit additif pouvant rendre impossible l'exploitation de la mesure. L'élimination de cette perturbation, que l'on appelle « bruit *d'interférence* », est donc une nécessité.

Les sources $S_0$, ..., $S_{p-1}$ émettent les différents signaux de test sur le réseau 20. Le réflectomètre 21, qui correspond à une source $S_0$, reçoit une somme $\Sigma$ de tous ces signaux filtrés par le réseau 20. $H_{p1,p2}$ représente la fonction de transfert du chemin parcouru par le signal entre les réflectomètres $p_1$ et $p_2$.

Le document référencé [1] en fin de description décrit une méthode de réflectométrie, qui consiste à utiliser des séquences pseudo-aléatoires de type séquence M (ou « Maximum length sequence ») comme signal de test et à minimiser l'intercorrélation entre les séquences générées par les différents réflectomètres. Le post-traitement (algorithme de discrimination) consiste ensuite à appliquer un filtrage adapté comme dans la méthode STDR (« Sequence Time Domain Reflectometry »).

Une telle méthode de réflectométrie ainsi décrite dans le document référencé [1] présente notamment les inconvénients suivants :

- Elle ne permet pas une annulation complète de la contribution des autres réflectomètres. Il reste un bruit résiduel,
- Elle impose l'utilisation d'un signal de type séquence M (ou LFSR, « Logical Feedback Shift Register » à longueur maximum). En effet, dans certains cas d'application, des signaux de test, tels que les signaux multiporteuses, peuvent être nécessaires du fait des contraintes de l'application considérée.

L'invention a pour objet un dispositif et un procédé de réflectométrie distribuée dite « à moyenne pondérée » permettant de résoudre ces inconvénients en améliorant la précision de mesure.

## EXPOSÉ DE L'INVENTION

L'invention concerne un dispositif de réflectométrie distribuée pour le diagnostic d'un réseau filaire, comportant au moins une ligne de transmission et des réflectomètres connectés en plusieurs points de ce réseau filaire, caractérisé en que chacun de ces réflectomètres comprend :

- une partie émission d'un signal de test x (t) dans une ligne, qui comporte :

  - une première mémoire contenant au moins un signal test s de N échantillons,
  - une seconde mémoire contenant M coefficients de pondération permettant de différencier chaque réflectomètre,
  - un premier multiplieur dudit signal test s de N échantillons avec un coefficient de pondération $\beta_m$, correspondant à une mesure m, délivrant un vecteur x,
  - un convertisseur numérique-analogique relié à la ligne,

- une partie réception d'un signal de mesure y(t) de la ligne, qui comporte :

  - un convertisseur analogique-numérique recevant ce signal de mesure y(t) de la ligne et délivrant un vecteur $\hat{\underline{y}}^{(m)}$ pour la mesure m,
  - un second multiplieur de ce vecteur $\hat{\underline{y}}^{(m)}$ avec le coefficient de pondération $\beta_m$ correspondant à la mesure m,

  - un module de moyennage effectuant la moyenne $\hat{\underline{y}} = \dfrac{1}{\beta} \sum\limits_{m=0}^{M-1} \beta_m \hat{\underline{y}}^{(m)}$ , permettant d'annuler la contribution des autres réflectomètres,
  - un module de post-traitement et d'analyse permettant d'obtenir des informations sur la structure du réseau ou sur les défauts électriques présents sur ce réseau.

Dans une application, le nombre de mesures est tel que : M=kM$_{min}$, avec : k∈N et M$_{min}$ nombre de mesures minimum.

Dans le cas où les réflectomètres sont synchronisés entre eux, les vecteurs sont orthogonaux entre eux, soit : $\underline{b}^T_{(p1)} \underline{b}_{(p2)} = 0$ . Avantageusement, le nombre de mesures minimum Mmin est égal au nombre p de réflectomètres et les coefficients de pondération sont tels que $\beta_m^{(p)} = \left[ H_p \right] p, m$ , H$_p$ étant la matrice de Hadamar d'ordre p. Dans le cas où les réflectomètres ne sont pas synchronisés entre eux, les vecteurs de pondération respectent la condition suivante :

$$\forall d \in 0, \ldots, M-1$$

$$\underline{b}^T_{(p1)} \prod{}^d \underline{b}_{(p2)} = 0$$

où d désigne le nombre d'échantillons de décalage entre les deux réflectomètres et Π la matrice de permutation circulaire. Avantageusement, le nombre de mesures minimum peut être égal à deux fois le nombre p de réflectomètres et les coefficients de pondération sont des sinusoïdes. Le nombre de mesures minimum Mmin peut être tel que M$_{min}$=2$^{p-1}$, et les coefficients de pondération sont tels que $\beta_m^{(p)} = sign\left[\sin(2^p\dfrac{\pi m}{M})\right]$, qui est une fonction de Rademacher.

Avantageusement, ce dispositif est un dispositif de réflectométrie distribuée pour le diagnostic en ligne d'un réseau filaire.

L'invention concerne également un procédé de réflectométrie distribuée pour le diagnostic d'un réseau filaire, comportant au moins une ligne de transmission, des réflectomètres connectés en plusieurs points de ce réseau filaire et une première mémoire contenant au moins un signal test s de N échantillons, caractérisé en ce que, mis en oeuvre dans chacun de de ces réflectomètres, il comprend les étapes suivantes :

- en émission d'un signal de test x (t) dans une ligne :

    - une étape de multiplication dudit signal test s de N échantillons avec un coefficient de pondération $\beta_m$ correspondant à une mesure m, mémorisé dans une mémoire, délivrant un vecteur x,
    - une étape de conversion numérique-analogique délivrant un signal x(t) relié à la ligne,

- en réception d'un signal de mesure y (t) de la ligne :

    - une étape de conversion analogique-numérique recevant un signal y(t) de la ligne et délivrant un vecteur $\hat{\underline{y}}^{(m)}$ pour la mesure m,
    - une étape de multiplication de ce vecteur avec le coefficient de pondération $\beta_m$ correspondant à la mesure m,
    - une étape de moyennage effectuant la moyenne $\hat{\underline{y}} = \dfrac{1}{\beta}\sum_{m=0}^{M-1}\beta_m\hat{\underline{y}}^{(m)}$, permettant d'annuler la contribution des autres réflectomètres,
    - une étape de post-traitement et d'analyse permettant d'obtenir des informations sur la structure de réseau ou sur les défauts électriques présents sur ce réseau.

Dans une application, le nombre de mesures est tel que : $M=kM_{min}$, avec : $k\in N$ et $M_{min}$ nombre de mesures minimum.

Dans le cas où les réflectomètres sont synchronisés entre eux, les vecteurs sont orthogonaux entre eux, soit : $\underline{b}_{(p1)}^T\underline{b}_{(p2)} = 0$. Avantageusement, le nombre de mesures minimum Mmin est égal au nombre p de réflectomètres et les coefficients de pondération sont tels que : $\beta_m^{(p)} = \left[H_p\right]p, m$, $H_p$ étant la matrice de Hadamar d'ordre p.

Dans le cas où les réflectomètres ne sont pas synchronisés entre eux, les vecteurs de pondération respectent la condition suivante :

$$\forall d \in o, \ldots, M-1$$

$$\underline{b}_{(p1)}^T\prod{}^d\underline{b}_{(p2)} = 0$$

où d désigne le nombre d'échantillons de décalage entre les deux réflectomètres et $\Pi$ la matrice de permutation circulaire. Avantageusement, le nombre de mesures minimum Mmin est égal à deux fois le nombre p de réflectomètres et les coefficients de pondération sont des sinusoïdes. Le nombre de mesure minimum Mmin peut être tel que $M_{min}=2^{p-1}$ et les coefficients de pondération sont tels que : $\beta_m^{(p)} = sign\left[\sin(2^p\dfrac{\pi m}{M})\right]$, qui est une fonction de Rademacher.

Avantageusement, le procédé de l'invention est un procédé de réflectométrie distribuée pour le diagnostic en ligne d'un réseau.

Le procédé de l'invention propose un nouvel algorithme de discrimination du signal de réflectométrie de complexité assez faible, qui permet une intégration facile de la réflectométrie à moyenne pondérée dans un système embarqué.

Deux principaux avantages se dégagent du dispositif et du procédé de l'invention :

- La perturbation issue des autres signaux de test, correspondant aux autres réflectomètres présents sur le réseau, peut être totalement annulée, là où elle est seulement atténuée avec d'autres méthodes de l'art connu.
- Le signal de test utilisé est complètement indépendant du procédé de l'invention et peut donc être choisi en fonction des contraintes de l'application. Une telle caractéristique est particulièrement intéressante dans le cas d'un diagnostic en ligne c'est-à-dire lorsque le réseau est diagnostiqué pendant que le système cible est en fonctionnement. En effet, dans une telle application on peut être amené à utiliser des signaux de test particuliers répondant à certaines contraintes afin de limiter les interférences entre la réflectométrie et le système cible (eg: réflectométrie multiporteuse).

De nombreuses applications du dispositif et du procédé de l'invention sont possibles, notamment dans les domaines automobile, avionique, ...

BRÈVE DESCRIPTION DES DESSINS

- La figure 1 illustre le synoptique d'un dispositif de diagnostic par réflectométrie de l'art connu.
- La figure 2 illustre le schéma de principe d'un dispositif de réflectométrie distribuée.
- La figure 3 illustre le schéma synoptique du dispositif de réflectométrie distribuée à moyenne pondérée selon l'invention.
- La figure 4 illutre le schéma d'un réseau utilisé pour la mise en oeuvre du procédé de l'invention.
- La figure 5 illustre des résultats donnés par les trois réflectomètres du réseau de la figure 4.
- la figure 6 illustre la détection d'un court-circuit sur la branche $I_5$ de la figure 4.

EXPOSÉ DÉTAILLÉ DE MODES DE RÉALISATION PARTICULIERS

Dans la suite, on utilise les notations suivantes :

a : scalaire réel ou complexe
$\underline{a}$ : vecteur réel ou complexe
$\underline{a}_k$ : $k^{ème}$ composante du vecteur ou signal a
a(t) : signal continu réel ou complexe
A(f) : transformée de Fourier du signal continu a(t)
A : matrice réelle ou complexe
R : ensemble des réels
N : ensemble des entiers naturels.

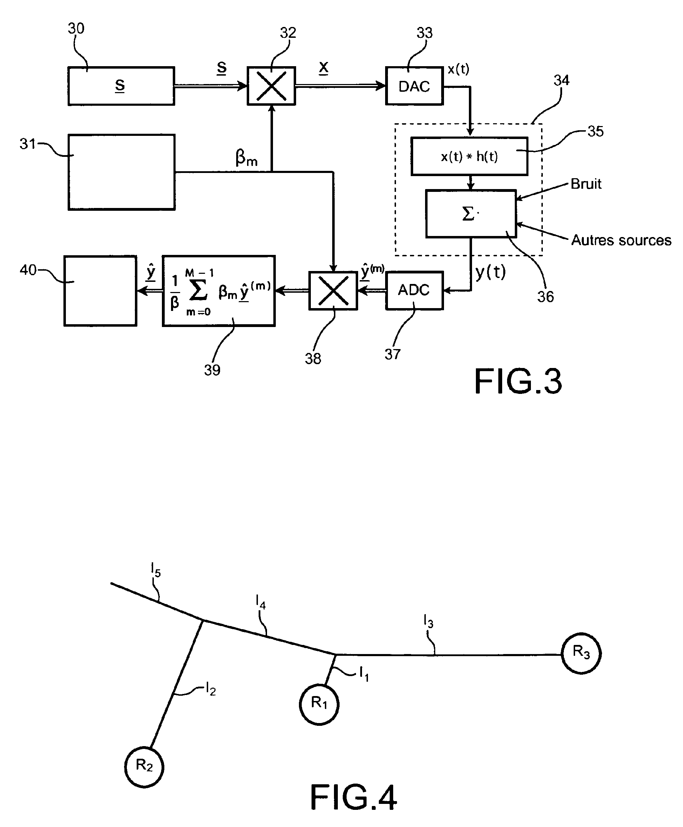

Le dispositif de l'invention, illustré sur la figure 3, comprend :

• une partie émission qui comporte successivement :

- une première mémoire 30 contenant au moins un signal test $\underline{s}$ de N échantillons,
- une seconde mémoire 31 contenant M coefficients de pondération permettant de différencier chaque réflectométre,
- un premier multiplieur 32 d'un signal test $\underline{s}$ avec un coefficient $\beta_m$ correspondant à une mesure m, délivrant un vecteur $\underline{x}$,
- un convertisseur numérique-analogique (DAC) 33 délivrant un signal x(t) relié au système physique 34, c'est-à-dire à la ligne 35, le module $\Sigma$ 36 symbolisant la contribution des autres sources et du bruit,

• une partie réception qui comporte successivement :

- un convertisseur analogique-numérique (ADC) 37 recevant un signal y(t) de la ligne et délivrant un vecteur $\hat{\underline{y}}^{(m)}$ pour la mesure m,
- un second multiplieur 38 de ce vecteur $\hat{\underline{y}}^{(m)}$ avec le coefficient $\beta_m$, $\hat{\underline{y}}(m)$ avec le coefficient $\beta_m$,

- un module de moyennage effectuant la moyenne $\dfrac{1}{\beta}\displaystyle\sum_{m=0}^{M-1}\beta_m\,\underline{\hat{y}}^{\,(m)}=\underline{\hat{y}}$ ,

- un module de post-traitement et d'analyse 40.

Les convertisseurs 33 et 37 peuvent être respectivement déplacés :

- entre la première mémoire 30 et le premier multiplieur 32, et
- entre le second multiplieur 38 et le module de moyennage 39.

Dans le cas d'un diagnostic filaire monosource, une mesure correspond à une série de M séquences ($\underline{x}_0$, ..., $\underline{x}_{M-1}$) aboutissant à M mesures ($\underline{y}_0$, ..., $\underline{y}_{M-1}$). Une moyenne de ces M mesures est ensuite calculée selon la relation (3), qui s'écrit :

$$\underline{\hat{y}} = \frac{1}{M}\sum_{m=0}^{M-1}\underline{y}^{(m)} \qquad\qquad (3)$$

M : est le nombre de mesures
$\underline{y}^{(m)}$ : est la m$^{\text{ème}}$ mesure.
Le procédé de l'invention consiste à insérer une suite de coefficients de pondération ($\beta_0$, ..., $\beta_{M-1}$). Ces coefficients sont appliqués aux séquences émises ce qui aboutit à la relation

$$\underline{x}_m = \beta_m^{(p)}\underline{s}' = \beta_m^{(p)}\begin{pmatrix}\underline{s}\\[2pt]\underline{s}\end{pmatrix} \qquad\qquad (4)$$

où $\underline{s}= (s_1, s_2, ..., s_N)^T$ représente le signal test d'origine et s' correspond à deux périodes du signal d'origine (donc 2N échantillons). Chaque séquence émise contient deux périodes du signal d'origine pour pouvoir conserver une hypothèse de périodicité. En effet, si $\underline{x}_m$ est différent de $\underline{x}_{m-1}$, la première période correspond à un régime transitoire. On peut alors mesurer la réponse de la ligne en régime établi durant la deuxième période. La vraie période du signal émis est donc de 2.N.M échantillons.
La relation (4) peut être écrite sous forme matricielle. Pour cela, on introduit les notations suivantes :

- Vecteur de pondération :

$$b^{(p)} = \left(\beta_1^{(p)},\ \beta_2^{(p)},\ ...,\ \beta_M^{(p)}\right)$$

correspondant au réflectomètre p.
- Matrice d'émission qui contient le signal émis par une source considérée :

$$X = \begin{pmatrix}\underline{x}_1^T\\\underline{x}_2^T\\\vdots\\\underline{x}_M^T\end{pmatrix} = \left(\underset{N}{\underbrace{\tilde{X}}}\,\middle|\,\underset{N}{\underbrace{\hat{X}}}\right) = \begin{pmatrix}x_0 & \cdots & x_{N-1} & x_N & \cdots & x_{2-N-1}\\ x_{2N} & \cdots & x_{3N-1} & x_{3N} & \cdots & x_{4-N-1}\\ \vdots & & \vdots & \vdots & & \vdots\\ x_{(2M-2)N} & \cdots\ x_{(2M-1)N-1} & x_{(2M-1)N} & \cdots & x_{2MN-1}\end{pmatrix}$$

La relation (4) correspond alors à :

$$X=\underline{b}^{(p)}\underline{s}'^{\,T} \qquad\qquad (5)$$

- Matrice de réception qui contient les M mesures. Elle est définie de la même façon que X :

$$Y = \begin{pmatrix} \underline{y}_1^T \\ \underline{y}_2^T \\ \vdots \\ \underline{y}_M^T \end{pmatrix} = \left( \underbrace{\widetilde{Y}}_{N} \Big| \underbrace{\hat{Y}}_{N} \right) = \begin{pmatrix} y_0 & \cdots & y_{N-1} & y_N & \cdots & y_{2-N-1} \\ y_{2N} & \cdots & y_{3N-1} & y_{3N} & \cdots & y_{4-N-1} \\ \vdots & & \vdots & \vdots & & \vdots \\ y_{(2M-2)N} & \cdots & y_{(2M-1)N-1} & y_{(2M-1)N} & \cdots & y_{2MN-1} \end{pmatrix}$$

Chaque ligne correspond ici à une des M mesures.

La matrice $\widetilde{Y}$ correspond à la mesure du régime transitoire et est donc ignorée. La matrice de régime établi est donnée par la relation :

$$\hat{Y} = XH'^T + N \qquad (6)$$

où H' est une matrice Nx2N correspondant à la convolution avec la réponse de la ligne :

$$H' = \begin{pmatrix} 0 & h_0 & h_1 \ldots h_{N-1} & 0 & \cdots & 0 \\ 0 & 0 & h_0 \cdots h_{N-2} & h_{N-1} & \cdots & 0 \\ \vdots & \ddots & \ddots & \vdots & \vdots & \ddots & \vdots \\ 0 & 0 & 0 \cdots & h_0 & h_1 & \cdots h_{N-1} \end{pmatrix}$$

On considère que la réponse $h_n$ de la ligne est nulle pour n>N.
Etant donné que $\widetilde{X} = \hat{X}$, on peut réécrire la relation (6) en utilisant la matrice circulaire H. On obtient alors :

$$\hat{Y} = \hat{X}H^T + N \qquad (7)$$

où la matrice N représente le bruit additif de mesure et H est la matrice circulaire représentant la réponse de la ligne comme dans la relation (2). L'opération de moyenne pondérée peut alors s'écrire :

$$\underline{\hat{y}} = \frac{\displaystyle\sum_{m=0}^{M-1} \beta_m \underline{\hat{y}}_m}{\displaystyle\sum_{m=0}^{M-1} \beta_m^2} = \frac{\hat{Y}^T \underline{b}}{\underline{b}^T \underline{b}} \qquad (8)$$

En injectant (7) dans (8), on obtient :

$$\underline{\hat{y}} = \frac{1}{\beta}(H \underline{s}\underline{b}^T + N)\underline{b} = H\underline{s} + \frac{N\underline{b}}{\beta} \qquad (9)$$

où $\beta = \underline{b}^T\underline{b}$. On retrouve bien le même résultat que dans la relation (2). Seule l'expression du bruit est différente, en effet le rapport signal à bruit est plus grand.

Le principe de la modulation orthogonale consiste alors à paramètrer les coefficients $\beta_m^{(p)}$ de façon à ce que seul le signal provenant de la source voulue soit récupéré, le bruit d'interférence issu des autres sources étant annulé dans le moyennage.

On va, à présent, étudier comment les différents réflectomètres interagissent et en déduire les conditions que les coefficients de pondération doivent vérifier.

Interférences entre les sources

Si l'on considère qu'il n'y a aucune synchronisation entre les sources, le décalage temporel entre les coefficients pondérant les signaux tests issus des différentes sources et les coefficients du moyennage est totalement arbitraire. Ainsi pour pouvoir garantir la discrimination des signaux quelle que soit la désynchronisation entre les sources, les vecteurs de pondération doivent respecter la condition suivante pour $p_1 \neq p_2$ :

$$\forall d \in 0, ..., M-1 : \underline{b}_{(p1)}^T \prod{}^d \underline{b}(_{p2}) = 0 \qquad (10)$$

où d désigne le nombre d'échantillons de décalage entre les deux sources et $\Pi$ la matrice de permutation circulaire. Cette condition équivaut à ce que les couples de vecteurs de pondérations aient une fonction d'intercorrélation nulle.

Si, par contre, les différentes sources sont synchronisées (ie $d_p$=0) les vecteurs doivent être orthogonaux entre eux :

$$\underline{b}_{(p1)}^T \underline{b}_{(p2)} = 0 \qquad (11)$$

Le signal test contenu dans le vecteur $\underline{s}$ peut être quelconque contrairement à la méthode décrite dans les documents référencé [1] et [3]. Cette méthode peut donc être utilisée indifféremment pour de la réflectométrie de type STDR comme décrit dans le document référencé [4], ou multiporteuse comme décrit dans le document référencé [2] ou autre. Plusieurs familles de vecteurs obéissent aux conditions (10) et/ou (11).

Choix des coefficients de pondération

Le choix des coefficients de pondération doit satisfaire les conditions (10) et/ou (11), mais il doit également tenir compte de l'impact de ces coefficients en terme de rapport signal à bruit. On distingue les deux cas que sont un système synchrone correspondant à la condition (11) et un système asynchrone correspondant à la condition (10).

Dans chaque cas, on précise le nombre minimum de mesures à effectuer $M_{min}$. Le nombre M de mesures choisi dans l'application doit être un multiple de $M_{min}$ (M=k$M_{min}$, $k \in$ N) pour que la discrimination se fasse correctement.

• Système synchrone

Il s'agit du cas le plus simple car les vecteurs de pondération doivent juste être orthogonaux deux à deux. Pour satisfaire cette condition, on peut utiliser les fonctions de Hadamard, mais d'autres choix sont également possibles.

$$\Pi = \begin{pmatrix} 0 & \cdots & 0 & 1 \\ 1 & \ddots & 0 & 0 \\ \vdots & \ddots & \vdots & \vdots \\ 0 & \dots & 1 & 1 \end{pmatrix}$$

Pour utiliser les fonctions de Hadamard, on choisit de préférence un nombre de sources p égal à une puissance de 2 (P=2$^r$, r$\in$N*). Les coefficients de pondération sont alors donnés par :

$$\beta_m^{(p)} = \left[H_P\right]_{p,m} \qquad (12)$$

où $H_P$ est la matrice de Hadamard d'ordre P définie récursivement par :

$$H_{2P} = \begin{pmatrix} H_P & H_P \\ H_P & -H_P \end{pmatrix}, \quad \text{avec} \quad H_2 = \begin{pmatrix} 1 & 1 \\ 1 & -1 \end{pmatrix} \qquad (13)$$

Un nombre de mesure égal au nombre de sources ($M_{min}$=P) est suffisant pour que l'orthogonalité soit réalisée.

• Système asynchrone

Dans ce cas, les vecteurs de pondération doivent rester orthogonaux lorsqu'on leur applique une permutation circulaire d'un nombre quelconque d'échantillons. Deux solutions sont alors possibles pour le choix des coefficients.
La première solution consiste à utiliser des sinusoïdes par exemple :

$$\beta_m^{(p)} = \cos\left(2\pi \frac{mp}{M}\right) \qquad (14)$$

Le nombre de mesures nécessaires est juste le double du nombre de réflectomètres ($M_{min}$=2p). L'inconvénient des sinusoïdes est, d'une part, que le gain en rapport signal à bruit est un peu moins bon que pour la moyenne classique et, d'autre part, qu'un multiplieur est alors nécessaire dans la mise en oeuvre du système. En effet, lorsque les coefficients sont donnés par des fonctions binaires (1 ou -1) les multiplieurs peuvent être remplacés par une simple condition, ce qui allège la mise en oeuvre.
Dans une seconde solution, pour éviter l'utilisation d'un multiplieur, on utilise des fonctions de Rademacher qui sont des fonctions binaires. Les coefficients sont alors définis par :

$$\beta_m^{(p)} = sign\left[\sin\left(2^p \frac{\pi m}{M}\right)\right] \qquad (15)$$

On a ici $M_{min}$=$2^{P-1}$. Le nombre de mesures évolue donc exponentiellement avec le nombre de sources. Davantage de mesures sont donc nécessaires, ce qui peut devenir problématique pour un nombre important de réflectomètres.

Mise en oeuvre du procédé de l'invention

Le bon fonctionnement du procédé de réflectométrie distribuée de l'invention dépend de la précision des horloges cadençant les différents réflectomètres. En effet, la théorie présentée plus haut suppose que ces horloges aient la même fréquence. En pratique les erreurs sur les fréquences des oscillateurs sont inévitables. Pour garantir un fonctionnement correct du système, il faut que :

$$\frac{\Delta T_e}{T_e} \langle \frac{1}{N.M}$$

où $\dfrac{\Delta T_e}{T_e}$ est la tolérance relative à la période d'échantillonnage du signal de mesure.

L'algorithme de discrimination, à savoir les étapes de moyennage pondéré et de synthèse du signal peut être implanté sur une carte FPGA munie d'entrée/sortie analogiques. La structure du dispositif de l'invention convient relativement bien à une mise en oeuvre de type câblé pour un FPGA (« Field Programmable Gate Array »), un ASIC (« Application Specific Integrated Circuit » ou circuit intégré spécifique) ou une intégration dans un dispositif de type "on chip" (ou « sur puce »). Cependant une mise en oeuvre sur microcontrôleur est également envisageable.

Le procédé de réflectométrie distribuée par moyenne pondéré selon l'invention a été testé sur un réseau de lignes coaxiales $l_1$, $l_2$, $l_3$, $l_4$ et $l_5$ sur lequel trois noeuds de mesures ont été connectés. Comme illustré sur la figure 4, les trois réflectomètres $R_1$, $R_2$ et $R_3$ sont connectés au réseau. La ligne $l_5$ se termine par un circuit ouvert. Les lignes ont toutes une impédance caractéristique de 50 Ω. Il y a donc une rupture d'impédance à chaque bifurquation (ou « Y »). Ces lignes $l_1$ à $l_5$ ont respectivement des longueurs de 0,6 m ; 2 m ; 3 m ; 2 m et 1,5 m.

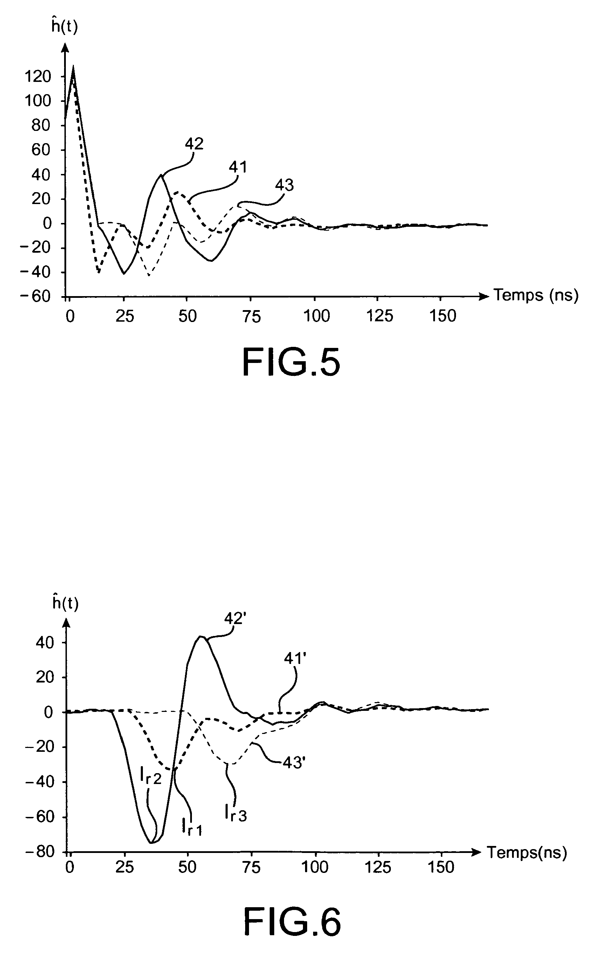

Le signal test de chaque réflectomètre est une séquence pseudo-aléatoire de 64 échantillons émis à une cadence de 100 MHz. Le signal reçu est échantillonné avec une fréquence de 600 MHz. Le nombre de mesures moyennées est M = 32. On ne suppose dans cette mesure aucune synchronisation entre les différents réflectomètres, les coefficients de pondération sont donc définis par les fonctions de Rademacher. Les réflectogrammes 41, 42, 43 fournis respectivement par les trois réflectomètres $R_1$, $R_2$, $R_3$ sont représentés sur la figure 5. On remarque que l'identification du réseau est assez difficile en raison de nombreux échos secondaires. Un post-traitement d'analyse peut être appliqué sur ce résultat afin d'en extraire, par exemple la topologie du réseau. En revanche, aucun bruit d'interférence n'est présent.

Afin d'analyser un résultat directement exploitable, un défaut (court-circuit 1 mètre avant le bout de la branche $l_5$) est créé sur le réseau. Puis la différence 41', 42' et 43' entre les nouveaux réflectogrammes obtenus et les originaux de la figure 5 sont calculés. Les résultats obtenus sont visibles figure 6.

Ce type d'opération peut facilement être réalisé dans le cas d'un diagnostic en ligne (ie: diagnostic en continu pendant le fonctionnement du système cible). L'information concernant le défaut est alors donnée par le premier pic de chaque courbe. Si l'on se reporte au schéma du réseau figure 4 et sachant que le court-circuit est situé à 50 cm du « Y », la position du premier pic par rapport à l'origine correspond à :

- $L_{r1}$ = $l_1$+$l_4$+0,5 = 3,1 m pour R1.
- $L_{r2}$ = $l_2$+0,5 = 2, 5 m pour R2.
- $L_{r3}$ = $l_3$+$l_4$+0,5 = 5,5 m pour R3.

Pour les câbles utilisés, la vitesse de propagation est $v \approx \dfrac{2}{3} C_{lum} = 0.2.10^9 \, m.s^{-1}$. Le temps de propagation (aller-retour) est alors donné par $t_i = 2 \dfrac{l_i}{v} + t_0$ . La valeur $t_0$, qui correspond au délai de propagation dans le système de mesure, est donnée par le premier pic de la figure 5 et correspond ici à environ 6 ns. On obtient alors :

$t_1 \approx 37$ ns, $t_2 \approx 32$ ns, $t_3 \approx 62$ ns.

Grâce à ces trois informations, et connaissant la structure du réseau d'origine, on peut connaître la position précise du défaut sur le réseau. La polarité négative des trois pics indique qu'il s'agit d'une chute de l'impédance. Enfin la différence d'amplitude s'explique par le nombre de « Y » traversés par le signal. En effet, le signal des réflectomètres $R_1$ et $R_3$ traversent deux « Y » contre un seul pour $R_2$. Cette connaissance précise du parcours de chaque signal permet une meilleure interprétation de l'amplitude des pics, ce qui présente un grand intérêt pour la détection de défauts non francs.

**Références**

[1] FR 2 907 910

[2] "Multicarrier reflectometry", de S. Naik, C.M. Furse, et B. Farhang-Boroujeny (ensors Journal IEEE, 6(3):812-818, juin 2006).

[3] "Distributed reflectometry-based diagnosis for complex wired networks" de N. Ravot, F. Auzanneau, Y. Bonhomme, M.O. Carrion, et F. Bouillault (EMC:Safety, Reliability and Security of Communication and Transportation Syst, EMC Workshop, Paris, juin 2007).

[4] "Analysis of spread spectrum time domain reflectometry for wire fault location", de P. Smith, C. Furse, et J. Gunther (Sensors Journal IEEE, 5(6):1469-1478, Dec. 2005).

**Revendications**

1. Dispositif de réflectométrie distribuée pour le diagnostic d'un réseau filaire, comportant au moins une ligne de transmission et des réflectomètres connectés en plusieurs points de ce réseau filaire, caractérisé en que chacun de ces réflectomètres comprend :

   • une partie émission d'un signal de test (x (t)) dans une ligne (35), qui comporte :

      - une première mémoire (30) contenant au moins un signal test s de N échantillons,
      - une seconde mémoire (31) contenant M coefficients de pondération permettant de différencier chaque réflectcmètre,
      - un premier multiplieur (32) dudit signal test s de N échantillons avec un coefficient de pondération $\beta_m$, correspondant à une mesure m, délivrant un vecteur (x),
      - un convertisseur numérique-analogique (33) relié à la ligne (35),

   • une partie réception d'un signal de mesure (y (t)) de la ligne (35), qui comporte :

      - un convertisseur analogique-numérique (37) recevant ce signal de mesure (y(t)) de la ligne (35) et délivrant un vecteur ($\underline{\hat{y}}^{(m)}$) pour la mesure m,
      - un second multiplieur (38) de ce vecteur ($\underline{\hat{y}}^{(m)}$) avec le coefficient de pondération $\beta_m$ correspondant à la mesure m,

      - un module de moyennage (39) effectuant la moyenne $\underline{\hat{y}} = \frac{1}{\beta} \sum_{m=0}^{M-1} \beta_m \underline{\hat{y}}^{(m)}$, permettant d'annuler la contribution des autres réflectomètres,

      - un module de post-traitement et d'analyse (40) permettant d'obtenir des informations sur la structure du réseau ou sur les défauts électriques présents sur ce réseau.

2. Dispositif selon la revendication 1, dans lequel, dans une application, le nombre de mesures est tel que : $M=kM_{min}$, avec : $k \in N$ et $M_{min}$ nombre de mesures minimum.

3. Dispositif selon la revendication 2, dans lequel, dans le cas où les réflectomètres sont synchronisés entre eux, les vecteurs sont orthogonaux entre eux, soit $\underline{b}_{(p1)}^T \underline{b}_{(p2)} = 0$ .

4. Dispositif selon la revendication 3, dans lequel le nombre de mesures minimum Mmin est égal au nombre p de réflectomètres et les coefficients de pondération sont tels que : $\beta_m^{(p)} = \left[ H_p \right] p, m$ , $H_p$ étant la matrice de Hadamar d'ordre p.

5. Dispositif selon la revendication 2, dans lequel, dans le cas où les réflectomètres ne sont pas synchronisés entre eux, les vecteurs de pondération respectent la condition suivante :

$$\forall d \in o, \ldots, M-1$$

$$\underline{b}_{(p1)}^T \prod{}^d \underline{b}(_{p2}) = 0$$

où d désigne le nombre d'échantillons de décalage entre les deux réflectomètres et $\Pi$ la matrice de permutation circulaire.

**6.** Dispositif selon la revendication 5, dans lequel le nombre de mesures minimum Mmin est égal à deux fois le nombre p de réflectomètres et les coefficients de pondération sont des sinusoïdes.

**7.** Dispositif selon la revendication 5, dans lequel le nombre de mesure minimum Mmin est tel que $M_{min}=2^{p-1}$ et les coefficients de pondération sont tels que : $\beta_m^{(p)} = sign\left[\sin(2^p \frac{\pi m}{M})\right]$ qui est une fonction de Rademacher.

**8.** Dispositif selon la revendication 1, qui est un dispositif de réflectométrie distribuée pour le diagnostic en ligne d'un réseau filaire.

**9.** Procédé de réflectométrie distribuée pour le diagnostic d'un réseau filaire, comportant au moins une ligne de transmission, des réflectomètres connectés en plusieurs points de ce réseau filaire et une première mémoire (30) contenant au moins un signal test s de N échantillons, **caractérisé en ce que**, mis en oeuvre dans chacun de de ces réflectomètres, il comprend les étapes suivantes :

   • en émission d'un signal de test (x (t)) dans une ligne (35) :

      - une étape de multiplication dudit signal test s de N échantillons avec un coefficient de pondération $\beta_m$ correspondant à une mesure m, mémorisé dans une mémoire (31), délivrant un vecteur (x),
      - une étape de conversion numérique-analogique délivrant un signal (x(t)) relié à la ligne (35),

   • en réception d'un signal de mesure (y (t)) de la ligne (35) :

      - une étape de conversion analogique-numérique (37) recevant un signal (y(t)) de la ligne (35) et délivrant un vecteur ($\hat{y}^{(m)}$) pour la mesure m,
      - une étape de multiplication de ce vecteur avec le coefficient de pondération $\beta_m$ correspondant à la mesure m,

      - une étape de moyennage effectuant la moyenne $\underline{\hat{y}} = \frac{1}{\beta}\sum_{m=0}^{M-1}\beta_m \underline{\hat{y}}^{(m)}$, permettant d'annuler la contribution des autres réflectomètres,
      - une étape de post-traitement et d'analyse permettant d'obtenir des informations sur la structure de réseau ou sur les défauts électriques présents sur ce réseau.

**10.** Procédé selon la revendication 9, dans lequel, dans une application, le nombre de mesures est tel que : $M=kM_{min}$, avec : $k \in N$ et $M_{min}$ nombre de mesures minimum.

**11.** Procédé selon la revendication 10, dans lequel, dans le cas où les réflectomètres sont synchronisés entre eux, les vecteurs sont orthogonaux entre eux, soit : $\underline{b}_{(p1)}^T \underline{b}_{(p2)} = 0$

**12.** Procédé selon la revendication 11, dans lequel le nombre de mesures minimum Mmin est égal au nombre p de réflectomètres et les coefficients de pondération sont tels que : $\beta_m^{(p)} = \left[H_p\right]p,m$, $H_p$ étant la matrice de Hadamar d'ordre p.

**13.** Procédé selon la revendication 10, dans lequel, dans le cas où les réflectomètres ne sont pas synchronisés entre eux, les vecteurs de pondération respectent la condition suivante :

$$\forall d \in 0, ..., M-1$$

$$\underline{b}^{T}_{(p1)} \prod{}^{d} \underline{b}(_{p2}) = 0$$

où d désigne le nombre d'échantillons de décalage entre les deux réflectonètres et $\Pi$ la matrice de permutation circulaire.

**14.** Procédé selon la revendication 13, dans lequel le nombre de mesures minimum Mmin est égal à deux fois le nombre p de réflectomètres et les coefficients de pondération sont des sinusoïdes.

**15.** Procédé selon la revendication 13, dans lequel le nombre de mesure minimum Mmin est tel que $M_{min}=2^{p-1}$ et les coefficients de pondération sont tels que: $\beta_{m}^{(p)} = sign\left[\sin(2^{p}\frac{\pi m}{M})\right]$, qui est une fonction de Rademacher.

**16.** Procédé selon la revendication 9, qui est un procédé de réflectométrie distribuée pour le diagnostic en ligne d'un réseau filaire.

**Claims**

**1.** Distributed reflectometry device for diagnosing a wired network, comprising at least one transmission line and reflectometers connected at several points of said wired network, **characterised in that** these reflectometers include:

   - a portion for transmitting a test signal (x (t)) in a line (35), which comprises:

      -- a first memory (30) containing at least one test signal s of N samples,
      -- a second memory (31) containing M weighting coefficients enabling each reflectometer to be differentiated,
      -- a first multiplier (32) of said test signal s of N samples with a weighting coefficient $\beta_m$, corresponding to a measurement m providing a vector (x),
      -- a digital-to-analog converter (33) connected to the line (35),

   - a portion for receiving a measurement signal (y (t)) from the line (35), which comprises:

      -- an analog-to-digital converter (37) receiving this measurement signal (y(t)) from the line (35) and providing a vector ($\hat{\underline{y}}^{(m)}$) for the measurement m,
      -- a second multiplier (38) of this vector ($\hat{\underline{y}}^{(m)}$) with the weighting coefficient $\beta_m$ corresponding to the measurement m,

      -- an averaging module (39) producing the average $\hat{\underline{y}} = \frac{1}{\beta}\sum_{m=0}^{M-1}\beta_{m}\hat{\underline{y}}^{(m)}$ enabling the contribution of the other reflectometers to be cancelled,
      -- a post-processing and analysis module (40) enabling information about the structure of the network or about the electrical faults present on this network to be obtained.

**2.** Device according to claim 1, wherein, in one application, the number of measurements is such that: $M=kM_{min}$, with: $k \in N$ and $M_{min}$ the minimum number of measurements.

**3.** Device according to claim 2, wherein, in the case where the reflectometers are synchronised with one another, the vectors are orthogonal to one another, namely: $\underline{b}^{T}_{(p1)}\underline{b}_{(p2)} = 0$

**4.** Device according to claim 3, wherein the minimum number of measurements Mmin is equal to the number p of reflectometers and the weighting coefficients are such that: $\beta_{m}^{(p)} = \left[H_{p}\right]p,m$, $H_p$ being the Hadamar matrix of order p.

5. Device according to claim 2, wherein, in the case where the reflectometers are not synchronised with one another, the weighting coefficients meet the following condition:

$$\forall d \in 0, \ldots, M-1$$

$$\underline{b}^{T}_{(p1)} \prod{}^{d} \underline{b}(_{p2}) = 0$$

where d designates the number of offset samples between the two reflectometers and $\Pi$ the cyclic permutation matrix.

6. Device according to claim 5, wherein the minimum number of measurements Mmin is equal to twice the number p of reflectometers and the weighting coefficients are sine curves.

7. Device according to claim 5, wherein the minimum number of measurements Mmin is such that $M_{min}=2^{p-1}$ and the weighting coefficients are such that: $\beta_m^{(p)} = sign\left[ \sin(2^p \frac{\pi m}{M}) \right]$, which is a Rademacher function.

8. Device according to claim 1, which is a distributed reflectometry device for on-line diagnosis of a wired network.

9. Distributed reflectometry method for diagnosing a wired network, comprising at least one transmission line and several reflectometers connected at several points of said wired network and a first memory (30) containing at least one test signal s of N samples, **characterised in that**, implemented in each of these reflectometers, it includes the following steps :

- during transmission of a test signal (x (t)) in a line (35):

-- a step for multiplying said signal s of N samples with a weighting coefficient $\beta_m$ corresponding to a measurement m, stored in a memory (31) providing a vector (x),
-- a digital-to-analog conversion step providing a signal (x(t)) linked to the line (35),

- during reception of a measurement signal (y (t)) of the line (35):

-- an analog-to-digital conversion step (37) receiving a signal (y(t)) from the line (35) and providing a vector ($\hat{\underline{y}}^{(m)}$) for the measurement m,
-- a step for multiplying this vector with the weighting coefficient $\beta_m$ corresponding to the measurement m,

-- an averaging step producing the average $\hat{\underline{y}} = \frac{1}{\beta} \sum_{m=0}^{M-1} \beta_m \hat{\underline{y}}^{(m)}$ , enabling the contribution of the other reflectometers to be cancelled,
-- a post-processing and analysis step enabling information to be obtained about the structure of the network or about the electrical faults present on said network.

10. Method according to claim 9, wherein, in one application, the number of measurements is such that: $M=kM_{min}$, with: $k \in N$ and $M_{min}$ the minimum number of measurements.

11. Method according to claim 10, wherein, in the case where the reflectometers are synchronised with one another, the vectors are orthogonal to one another, namely: $\underline{b}^{T}_{(p1)} \underline{b}_{(p2)} = 0$

12. Method according to claim 11, wherein the minimum number of measurements Mmin is equal to the number p of reflectometers and the weighting coefficients are such that: $\beta_m^{(p)} = \left[ H_p \right] p, m$ , $H_p$ being the Hadamar matrix of order p.

**13.** Method according to claim 10, wherein, in the case where the reflectometers are not synchronised with one another, the weighting vectors meet the following condition:

$$\forall d \in 0, ..., M-1$$

$$\underline{b}_{(p1)}^T \prod{}^d \underline{b}(_{p2}) = 0$$

where d designates the number of offset samples between the two reflectometers and $\Pi$ the cyclic permutation matrix.

**14.** Method according to claim 13, wherein the minimum number of measurements Mmin is equal to twice the number p of reflectometers and the weighting coefficients are sine curves.

**15.** Method according to claim 13, wherein the minimum number of measurements Mmin is such that $M_{min}=2^{p-1}$ and the weighting coefficients are such that: $\beta_m^{(p)} = sign\left[ \sin(2^p \frac{\pi m}{M}) \right]$ , which is a Rademacher function.

**16.** Method according to claim 9, which is a distributed reflectometry method for on-line diagnosis of a wired network.

**Patentansprüche**

**1.** Vorrichtung zur verteilten Reflektometrie für die Diagnose eines Drahtnetzes, das mindestens eine Übertragungsleitung und Reflektometer umfasst, die an mehreren Punkten dieses Drahtnetzes verbunden sind, **dadurch gekennzeichnet, dass** jedes dieser Reflektometer Folgendes umfasst:

- einen Abschnitt zum Senden eines Testsignals (x(t)) in einer Leitung (35), der Folgendes umfasst:

- einen ersten Speicher (30), der mindestens ein Testsignal s mit N Abtastwerten enthält,
- einen zweiten Speicher (31), der M Gewichtungskoeffizienten enthält, die das Differenzieren jedes Reflektometers ermöglichen,
- einen ersten Multiplikator (32) des Testsignals s mit N Abtastwerten mit einem Gewichtungskoeffizienten $\beta_m$, der einer Messung m entspricht, der einen Vektor (x) liefert,
- einen Digital-Analogwandler (33), der an die Leitung (35) angeschlossen ist,

- einen Abschnitt zum Empfangen eines Messsignals (y(t)) der Leitung (35), der Folgendes umfasst:

- einen Analog-Digitalwandler (27), der dieses Messsignal (y(t)) der Leitung (35) empfängt und einen Vektor ($\hat{\underline{y}}^{(m)}$) für die Messung m liefert,
- einen zweiten Multiplikator (38) dieses Vektors ($\hat{\underline{y}}^{(m)}$) mit dem Gewichtungskoeffizienten $\beta m$, der der Messung m entspricht,
- ein Mittelungsmodul (39), das die Mittelung

$$\hat{\underline{y}} = \frac{1}{\beta} \sum_{m=0}^{M-1} \beta_m \hat{\underline{y}}^{(m)}$$

durchführt, die das Aufheben des Beitrags der anderen Reflektometer ermöglicht,
- ein Nachverarbeitungs- und Analysemodul (40), das das Erhalten von Informationen über die Struktur des Netzes oder über die in diesem Netz vorhandenen elektrischen Fehler ermöglicht.

**2.** Vorrichtung nach Anspruch 1, wobei in einer Anwendung die Anzahl von Messungen derart ist, dass: $M = kM_{min}$, mit $k \in N$ und $M_{min}$ Anzahl der Mindestmessungen.

**3.** Vorrichtung nach Anspruch 2, wobei in dem Fall, in dem die Reflektometer untereinander synchronisiert sind, die Vektoren untereinander orthogonal sind, das heißt $\underline{b}^{T}_{(p1)} \, \underline{b}_{(p2)} = 0$.

**4.** Vorrichtung nach Anspruch 3, wobei die Anzahl der Mindestmessungen Mmin gleich der Anzahl p der Reflektometer ist und die Gewichtungskoeffizienten derart sind, dass: $\beta_m^{(p)} = [H_p]p, m$ wobei $H_p$ die Hadamard-Matrix der Ordnung p ist.

**5.** Vorrichtung nach Anspruch 2, wobei in dem Fall, in dem die Reflektometer nicht untereinander synchronisiert sind, die Gewichtungsvektoren die folgende Bedingung erfüllen:

$$\forall \, d \, \in o, \dots, M - 1$$

$$\underline{b}^{T}_{(p1)} \Pi^{d} \underline{b}_{(p2)} = 0$$

wo d die Anzahl der Versatzabtastwerte zwischen den zwei Reflektometern und $\Pi$ die zyklische Permutationsmatrix bezeichnet.

**6.** Vorrichtung nach Anspruch 5, wobei die Anzahl der Mindestmessungen Mmin gleich zwei Mal die Anzahl p der Reflektometer ist und die Gewichtungskoeffizienten sinusförmig sind.

**7.** Vorrichtung nach Anspruch 5, wobei die Anzahl der Mindestmessungen Mmin derart ist, dass $M_{min} = 2^{p-1}$ und die Gewichtungskoeffizienten derart sind, dass: $\beta_m^{(p)} = sign\left[\sin\left(2^p \frac{\pi m}{M}\right)\right]$, die eine Rademacher-Funktion ist.

**8.** Vorrichtung nach Anspruch 1, die eine Vorrichtung zur verteilten Reflektometrie zur Online-Diagnose eines Drahtnetzes ist.

**9.** Verfahren zur verteilten Reflektometrie zur Diagnose eines Drahtnetzes, das mindestens eine Übertragungsleitung, Reflektometer, die an mehreren Punkten dieses Drahtnetzes verbunden sind, und einen ersten Speicher (30) umfasst, der mindestens ein Testsignal s mit N Abtastwerten enthält, **dadurch gekennzeichnet, dass** es die folgenden Schritte umfasst, wenn es in jedem dieser Reflektometer eingesetzt wird:

- beim Senden eines Testsignals (x(t)) in einer Leitung (35):

- einen Schritt der Multiplikation des Testsignals s mit N Abtastwerten mit einem in einem Speicher (31) gespeicherten Gewichtungskoeffizienten $\beta_m$, der einer Messung m entspricht, der einen Vektor (x) liefert,
- einen Schritt der Digital-Analog-Wandlung, der ein Signal (x(t)) liefert, das an die Leitung (35) abgeschossen ist,

- beim Empfang eines Messsignals (y(t)) der Leitung (35):

- einen Schritt der Analog-Digital-Wandlung (37), der ein Signal (y(t)) von der Leitung (35) empfängt und einen Vektor $(\hat{\underline{y}}^{(m)})$ für die Messung m liefert,
- einen Schritt der Multiplikation dieses Vektors mit dem Gewichtungskoeffizienten βm, der der Messung m entspricht,

- einen Mittelungsschritt, der die Mittelung

$$\underline{\hat{y}} = \frac{1}{\beta} \sum_{m=0}^{M-1} \beta_m \, \underline{\hat{y}}^{(m)}$$

durchführt, die das Aufheben des Beitrags der anderen Reflektometer ermöglicht,
- einen Schritt der Nachverarbeitung und der Analyse, der das Erhalten von Informationen über die Netzstruktur oder über die in diesem Netz vorhandenen elektrischen Fehler ermöglicht.

10. Verfahren nach Anspruch 9, wobei in einer Anwendung die Anzahl der Messungen derart ist, dass: $M = kM_{min}$, mit: $k \in N$ und $M_{min}$ Anzahl der Mindestmessungen.

11. Verfahren nach Anspruch 10, wobei in dem Fall, in dem die Reflektometer untereinander synchronisiert sind, die Vektoren untereinander orthogonal sind, das heißt $\underline{b}_{(p1)}^T \, \underline{b}_{(p2)} = 0$

12. Verfahren nach Anspruch 11, wobei die Anzahl der Mindestmessungen Mmin gleich der Anzahl p der Reflektometer ist und die Gewichtungskoeffizienten derart sind, dass: $\beta_m^{(p)} = [H_p]p, m$ wobei $H_p$ die Hadamard-Matrix der Ordnung p ist.

13. Verfahren nach Anspruch 10, wobei in dem Fall, in dem die Reflektometer nicht untereinander synchronisiert sind, die Gewichtungsvektoren die folgende Bedingung erfüllen:

$$\forall d \in o, \ldots, M-1$$

$$\underline{b}_{(p1)}^T \Pi^d \underline{b}_{(p2)} = 0$$

wo d die Anzahl der Versatzabtastwerte zwischen den zwei Reflektometer und $\Pi$ die zyklische Permutationsmatrix bezeichnet.

14. Verfahren nach Anspruch 13, wobei die Anzahl der Mindestmessungen Mmin gleich zwei Mal die Anzahl p der Reflektometer ist und die Gewichtungskoeffizienten sinusförmig sind.

15. Verfahren nach Anspruch 13, wobei die Anzahl der Mindestmessungen Mmin derart ist, dass $M_{min} = 2^{p-1}$ und die Gewichtungskoeffizienten derart sind, dass: $\beta_m^{(p)} = sign \left[ \sin \left( 2^p \frac{\pi m}{M} \right) \right]$, die eine Rademacher-Funktion ist.

16. Verfahren nach Anspruch 9, das ein Verfahren zur verteilten Reflektometrie für die Online-Diagnose eines Drahtnetzes ist.

FIG.1

FIG.2

FIG.3

FIG.4

FIG.5

FIG.6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2907910

**Littérature non-brevet citée dans la description**

- **DE S. NAIK ; C.M. FURSE ; B. FARHANG-BOROUJENY.** Multicarrier reflectometry. *Journal IEEE,* Juin 2006, vol. 6 (3), 812-818
- **DE N. RAVOT ; F. AUZANNEAU ; Y. BONHOMME ; M.O. CARRION ; F. BOUILLAULT.** Distributed reflectometry-based diagnosis for complex wired networks. *Distributed reflectometry-based diagnosis for complex wired networks,* Juin 2007
- **DE P. SMITH ; C. FURSE ; J. GUNTHER.** Analysis of spread spectrum time domain reflectometry for wire fault location. *Analysis of spread spectrum time domain reflectometry for wire fault location,* Décembre 2005, vol. 5 (6), 1469-1478